# DEMANDE DE BREVET EUROPEEN

(11) **EP 1 557 480 A2**
(43) Date de publication de la demande: **27.07.2005**
(21) Numéro de dépôt: 04293083.4
(22) Date de dépôt: 22.12.2004
(51) Int. Cl.: C23C 14/22, C23C 14/30, C23C 14/54, C23C 14/46

(54) **Procédé et dispositif de réalisation d'une couche catalytique**

(30) Priorité: 23.12.2003 FR 0315254
(71) Demandeur: SAGEM SA, 75015 Paris (FR)
(72) Inventeur: Tigreat, Delphine, 92600 Asnières sur Seine (FR); Bergamasco, Jean-Luc, 75018 Paris (FR); Boutin, Xavier, 78150 Le Chesnay (FR); Letourneur, Bruno, 95100 Argenteuil (FR)
(74) Mandataire: Texier, Christian

(57) **Abrégé**

L'invention concerne un procédé de dépôt sous vide d'une couche catalytique sur une électrode (4) à catalyse hétérogène dans une enceinte (31), caractérisé en ce qu'on assiste le dépôt sous vide du catalyseur par un bombardement ionique de l'électrode lors du dépôt du catalyseur.

L'invention concerne également un dispositif de mise en oeuvre du procédé.

## Description

La présente invention concerne une technique de réalisation d'une couche catalytique sur une électrode.

Plus précisément, elle concerne une technique permettant de réaliser une couche catalytique sur des électrodes pour des applications de catalyse hétérogène.

### ETAT DE L'ART

Certaines piles de systèmes électroniques utilisent des dispositifs électrochimiques comportant des électrodes à gaz ou à liquides.

Certaines de ces électrodes à gaz ou à liquides sont utilisées par exemple dans des piles à combustibles.

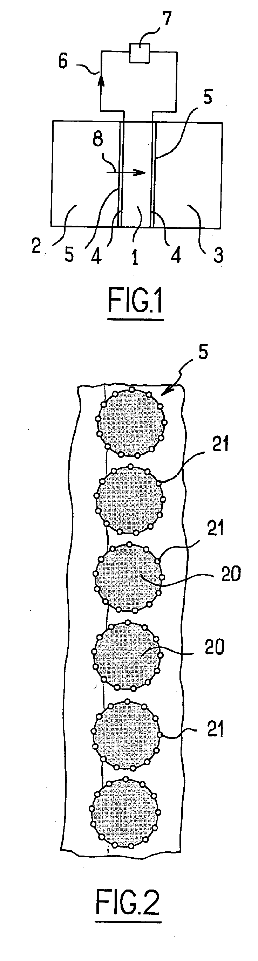

La figure 1 montre un schéma de principe d'une telle pile selon l'art antérieur.

La pile de la figure 1 transforme l'énergie chimique, stockée dans un carburant 2, en énergie électrique par un procédé électrochimique qui consiste à faire réagir un gaz carburant 2, ou un liquide dans certaines applications, avec un oxydant 3 en présence d'un électrolyte 1, d'électrodes 4 et d'un catalyseur 5.

Plus précisément, le catalyseur 5 favorise l'oxydation du carburant 2 à l'électrode négative et la réduction de l'oxydant à l'électrode positive dans certaines applications. Ces réactions libèrent à l'électrode négative des électrons 6 qui circulent par un circuit externe incorporant une charge 7, pendant que les ions 8 résultant soit de l'oxydation soit de la réduction traversent le matériau électrolytique séparant les deux électrodes 4.

Il existe plusieurs types d'électrolytes 1. Certains électrolytes sont en phase solide, d'autres en phase liquide.

Le matériau électrolytique 1 peut être par exemple mis dans les pores d'une membrane poreuse séparant le carburant 2 et l'oxydant 3, la membrane étant par ailleurs imperméable au carburant 2 et à l'oxydant 3.

Le catalyseur 5 est déposé sur les deux faces de la membrane de séparation puis une couche conductrice électrique est déposée sur chaque face de l'ensemble catalyseur/électrolyte pour réaliser l'ensemble électrode/membrane.

Les électrodes 4 peuvent également être en graphite dans le cas de carburant et/ou d'oxydant gazeux par exemple, le catalyseur étant alors déposé directement sur les électrodes. Les électrodes peuvent être dans d'autres matériaux ou d'autres formes lorsque le carburant et/ou l'oxydant sont liquides.

La figure 2 montre un schéma de principe d'une couche catalytique 5 formant une couche active soit sur un ensemble électrode/membrane, la membrane formant une couche de diffusion protonique, soit sur une électrode en graphite selon l'art antérieur.

On remarque ainsi que la couche catalytique 5 comporte des grains de carbone 20 portant à leur surface des particules 21 de catalyseur actif. Les particules 21 de catalyseur sont souvent du palladium, du platine, du ruthénium ou du rhodium.

Cette association des grains 20 de carbone avec les particules 21 de catalyseur permet de donner à la couche active la surface de contact nécessaire à la catalyse de la réaction électrochimique.

On connaît par ailleurs de nombreuses techniques de réalisation de couches actives catalytiques selon la figure 2.

Certaines de ces techniques utilisent l'imprégnation en phase liquide du catalyseur sur les particules de carbone. Une fois que l'imprégnation des particules de carbone est effectuée, on réalise une enduction des électrodes par la phase liquide.

D'autres techniques réalisent la couche catalytique par imprégnation d'un support poreux conducteur électrique par des particules de carbone supportant le catalyseur.

Certaines encore comportent une étape de préparation de couches de matériaux à base de polymères, de liquides inorganiques et optionnellement de poudre, sous forme de pâte pour l'application sur les électrodes.

On finalise parfois la fabrication des électrodes en effectuant par exemple un chauffage, pour permettre notamment une évaporation des liquides.

Enfin, une autre technique de réalisation de la couche catalytique, la couche étant différente de celle représentée à la figure 2, utilise la technique du dépôt de couches minces sous vide. On chauffe alors sous vide un catalyseur actif de sorte qu'il vienne se déposer naturellement sur l'électrode.

Les techniques précédentes présentent cependant des inconvénients.

On sait en effet qu'un catalyseur est d'autant plus efficace qu'il est finement divisé, car la surface de contact avec les réactifs est accrue.

Or, les techniques de l'art antérieur ne permettent notamment pas le contrôle précis des tailles des particules catalytiques, dans le domaine des particules nanométriques.

Elles ne permettent pas non plus le contrôle de la configuration des particules entre elles, et notamment du taux de recouvrement.

Enfin, elles ne permettent pas un contrôle précis de l'épaisseur de la couche catalytique, ni de la force d'adhérence des couches.

Ce manque de précision des techniques de dépôt sur les dimensions des particules et de la couche catalytique en général fait que l'on doit ajouter beaucoup de catalyseur pour en avoir une quantité suffisante pour la réaction.

Les couches catalytiques sont par conséquent onéreuses - les particules catalytiques sont en effet très chères - et peu efficaces. On estime en effet qu'environ 80% des particules de catalyseur sont inactives dans les couches catalytiques de l'art antérieur appliqué à l'utilisation en électrode à air.

Ces inconvénients font que les performances des électrodes sont insuffisantes par rapport à leur coût, notamment pour les applications en téléphonie portable.

Les documents EP 0 657 998 et US 2002/127438 divulguent par ailleurs des techniques de dépôt sous vide de particules, le dépôt étant assisté par bombardement ionique. Ils divulguent des techniques de dépôt de particules dans des domaines d'application qui sont très éloignés des techniques de réalisation de couche catalytique pour des électrodes à catalyse hétérogène.

La technique divulguée par le document EP 0 657 998 concerne le dépôt d'un film de particules sur un dispositif à ondes acoustiques de surface. La technique divulguée par ce document cherche à résoudre le problème de la migration des contraintes lors de la propagation d'une onde de surface sur un tel dispositif. Le bombardement ionique permet de densifier le nombre de particules déposées sur un matériau piézo-électrique constitutif du dispositif, tout en permettant une croissance du film selon une orientation cristallographique identique à celle du matériau piézo-électrique. A cet effet, l'orientation cristallographique du réseau du matériau piézo-électrique est constante lors du dépôt et du bombardement. Une grande quantité de particules est alors déposée sur une épaisseur de l'ordre de 2000 angströms, mais avec une croissance épitaxiale du film déposé sur le matériau piézo-électrique. Une telle croissance épitaxiale permet de répartir uniformément les contraintes, et par conséquent d'augmenter la résistance du dispositif à la migration des contraintes.

La technique divulguée par le document US 2002/127438 concerne le dépôt d'un film optique sur une membrane flexible. Le film optique a des applications dans les filtres dichroïques ou les dispositifs à fort indice de réflexion. La technique divulguée par ce document cherche à résoudre le problème de la présence de contraintes de tension rémanentes dans les films optiques sur des membranes très minces. Des contraintes rémanentes sont en effet présentes dans de tels films optiques, notamment lorsque plusieurs couches de matériaux diélectriques différents sont déposées les unes sur les autres sur la membrane. Le bombardement ionique permet de densifier le nombre de particules déposées sur la membrane pour obtenir de forts indices indice de réflexion, tout en induisant des contraintes de compression qui contrecarrent les contraintes de tension. Le dépôt des couches des films s'effectue sur une épaisseur de l'ordre de 1 à 10 micromètres.

Ces documents ne divulguent pas de technique de réalisation de couche catalytique pour des électrodes à catalyse hétérogène. Ils ne divulguent pas de technique permettant de pallier les inconvénients des techniques de réalisation de couches catalytiques pour des électrodes à catalyse hétérogène.

En effet, dans les deux documents, le problème technique est le dépôt de particules non catalytiques selon une orientation cristallographique particulière pour une croissance épitaxiale du film à déposer, ou le dépôt de grosses particules diélectriques sur de grandes épaisseurs pour induire des contraintes de compression. Aucune de ses problématiques ne concerne la réalisation de couches catalytiques pour des électrodes à catalyse hétérogène, où il s'agit notamment de déposer sur une couche très mince de très petites particules de catalyseur pour obtenir une grande surface développée, le nombre de particules déposées étant le plus petit possible pour des questions de coût.

L'art antérieur ne divulgue pas de technique performante de réalisation d'une couche catalytique pour des électrodes à catalyse hétérogène.

### PRESENTATION DE L'INVENTION

L'invention propose de pallier ces inconvénients.

Un des buts de l'invention est de proposer une technique permettant notamment le contrôle précis des tailles des particules catalytiques, dans le domaine des particules nanométriques.

Un des autres buts de l'invention est de proposer une technique permettant le contrôle de la configuration des particules entre elles, et notamment du taux de recouvrement.

Un des autres buts de l'invention est de proposer une technique permettant un contrôle précis de l'épaisseur de la couche catalytique.

Un des autres buts de l'invention est de proposer une technique permettant un contrôle précis de la force d'adhérence des couches catalytiques.

Enfin, un but de l'invention est également de proposer une technique permettant la fabrication d'électrodes à gaz ou à liquides efficaces et peu onéreuses.

A cet effet, l'invention propose un procédé de dépôt sous vide d'une couche catalytique sur une électrode à catalyse hétérogène dans une enceinte, caractérisé en ce qu'on assiste le dépôt sous vide du catalyseur par un bombardement ionique de l'électrode lors du dépôt du catalyseur.

Des modes de réalisation préférentiels sont présentés dans les revendications dépendantes de procédé.

L'invention concerne également un dispositif de mise en oeuvre du procédé.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1, déjà commentée, montre un schéma de principe d'une pile à combustible utilisant une électrode à gaz ou à liquides ;
- la figure 2, déjà commentée, représente schématiquement une couche catalytique active sur une électrode ;
- la figure 3 représente schématiquement un dispositif possible de mise en oeuvre d'un procédé de dépôt d'une couche catalytique sur une électrode.

Dans des développements qui vont suivre, les éléments des figures ayant une structure similaire entre eux portent des références identiques.

### DESCRIPTION DETAILLEE

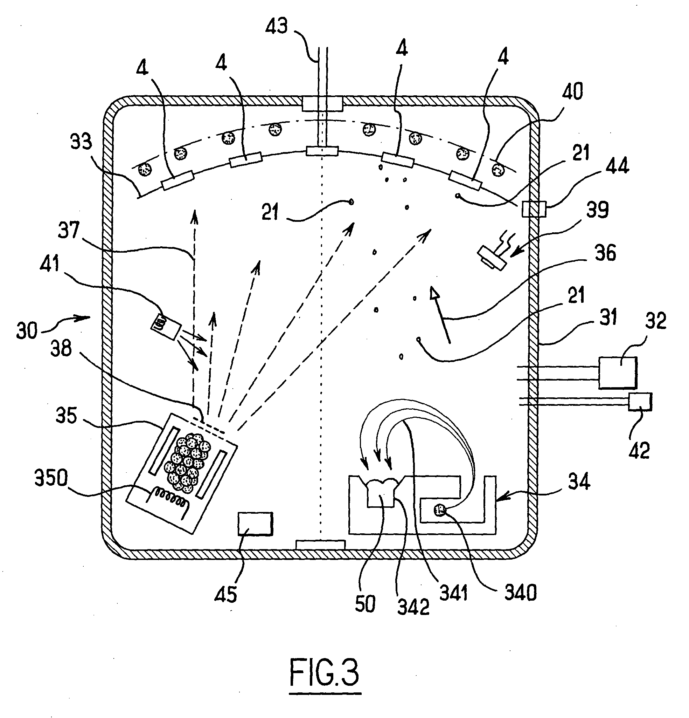

La figure 3 représente schématiquement un dispositif 30 possible de dépôt d'une couche catalytique sur au moins une électrode 4.

Chaque électrode 4 est une électrode à gaz ou à liquides comportant du graphite ou un support poreux conducteur électrique, préférentiellement une toile non tissée de carbone, ou en tissu de carbone ou en papier de carbone ou en un quelconque support de matière carbonée.

L'invention s'applique de façon non limitative à des électrolytes solides ou liquides de différents types de piles.

Dans la suite de la présente description on appelle « électrode » indifféremment une électrode en graphite ou un support poreux conducteur électrique, par exemple une toile non tissée de carbone ou en tissu de carbone ou en papier de carbone, ou en un quelconque support de matière carbonée. On peut cependant par exemple utiliser également des mousses métalliques.

Le dispositif 30 comporte principalement une enceinte 31 dans laquelle règne une faible pression.

A cet effet, le dispositif 30 comporte des moyens 32 de contrôle de la pression dans l'enceinte 31 et des moyens 42 permettant d'y faire le vide. Les moyens 42 peuvent comporter par exemple un système de pompage.

Le dispositif 30 comporte également des moyens 33 de support de l'électrode 4 dans l'enceinte 31 et des moyens 34 d'évaporation d'un matériau catalyseur 50 dans l'enceinte 31.

La nature du matériau catalyseur 50 est décrite plus en détail dans la suite de la présente description.

Les moyens 33 support sont situés en partie supérieure de l'intérieur de l'enceinte 31, tandis que les moyens 34 d'évaporation sont situés en partie inférieure de l'intérieur de l'enceinte 31. Ainsi, lorsque les particules 21 de catalyseurs s'évaporent à partir des moyens 34, elles se dirigent vers les moyens 33 support et viennent se déposer sur l'électrode 4 comme l'indique la flèche 36. Les moyens 33 se présentent préférentiellement sous la forme d'une calotte courbée en arc de cercle, le rayon de courbure étant tourné vers la partie inférieure de l'enceinte.

Les moyens 33 comportent avantageusement des moyens 43 aptes à les mettre en rotation selon un axe dirigé verticalement sur la figure 3. Le dépôt des particules 21 sur chaque électrode 4 est donc plus homogène grâce à cette rotation. La vitesse de rotation est bien entendu variable et réglable en fonction des différents types de dépôt que l'on souhaite effectuer.

Les moyens 34 peuvent par exemple être une source thermique. On chauffe alors le matériau catalyseur 50 à déposer sur l'électrode 4, le catalyseur étant sur les ou à proximité des moyens 34.

Des particules du matériau catalyseur 50 sont alors émises dans l'enceinte 31 et vont se déposer sur l'électrode 4.

La figure 3 montre également que les moyens 34 peuvent être une source par bombardement électronique.

On dispose alors le matériau catalyseur 50 dans un creuset 342 sur les moyens 34. Un filament métallique 340, également présent dans un creux des moyens 34, est chauffé afin de créer un faisceau d'électrons 341 qui vient bombarder le matériau catalyseur 50.

Des particules 21 du matériau catalyseur 50 sont alors émises dans l'enceinte 31 et vont se déposer sur l'électrode 4.

Le dispositif 30 comporte en outre des moyens 35 aptes à effectuer un bombardement ionique de l'électrode 4 lors du dépôt des particules 21 du catalyseur pour d'une part assister le dépôt sous vide du catalyseur et d'autre part contrôler les caractéristiques de la couche catalytique.

Les moyens 35 peuvent être associés à des moyens 41 permettant de neutraliser le faisceau d'ions pour éviter l'accumulation de charges positives sur la surface de l'électrode 4 lors du bombardement ionique.

De la même façon que les moyens 34, les moyens 35 sont situés dans la partie inférieure de l'enceinte 31. Le faisceau d'ions est représenté par les flèches 37 sur la figure 3. Il est dirigé vers la partie supérieure de l'enceinte, de sorte que le faisceau d'ions vienne percuter l'électrode 4 et les particules 21 de catalyseur sur chaque électrode 4.

On peut ainsi, grâce au faisceau 37, réorganiser la structure des particules 21 déposées sur chaque électrode 4.

On peut ainsi, en fonction de l'énergie cinétique du faisceau et de sa densité, et notamment en fonction de la taille des ions composant le faisceau 37 :
- densifier la couche catalytique en augmentant le nombre de particules 21 par unité de surface sur chaque électrode ;
- perturber la répartition des particules 21 sur les électrodes pour homogénéiser la répartition des particules et ainsi augmenter la surface développée de la couche catalytique.

Le contrôle d'une telle couche catalytique est impossible avec les techniques de l'art antérieur.

Dans le cas d'une perturbation de la couche catalytique, on évite la formation d'amas et de nucléations de particules 21. Les amas et les nucléations diminuent la surface développée de la couche catalytique. Une répartition plus homogène de fines particules 21 augmente la surface développée et favorise la réaction de catalyse.

Encore une fois, l'obtention d'une telle couche catalytique est impossible avec les techniques de l'art antérieur.

De plus, le fait de bombarder les particules 21 sur les électrodes augmente la force d'adhérence des couches catalytiques sur les électrodes 4.

Enfin, on peut contrôler l'épaisseur de pénétration des particules 21 dans le matériau de l'électrode 4. Préférentiellement, le dépôt s'effectue sur une épaisseur inférieure à 1000 angströms, typiquement inférieure 500 angströms. Très préférentiellement, l'épaisseur de la couche active de catalyse hétérogène est inférieure à 200 angströms.

La nature du faisceau d'ions est décrite plus en détail dans la suite de la présente description.

Les moyens 35 comportent des moyens 38 aptes à contrôler l'énergie cinétique du faisceau d'ions, ainsi que sa densité.

Les moyens 38 peuvent avantageusement être constitués d'une grille.

Le dispositif 30 comporte des moyens 39 formant balance à quartz apte à peser le dépôt sur un support témoin. L'augmentation de masse du support témoin est corrélée avec l'épaisseur du dépôt, et la vitesse d'augmentation est corrélée avec la vitesse de dépôt. Ce dispositif permet donc de contrôler l'épaisseur de dépôt et la vitesse de dépôt sur chaque électrode 4.

Il comporte en outre des moyens 40 aptes à contrôler la température à l'intérieur de l'enceinte. Les moyens 40 sont composés d'une part de moyens de chauffage et d'autre part de moyens de contrôle de la température. Les moyens 40 permettent notamment de chauffer les électrodes 4 pour certains dépôts.

Le dispositif 30 comporte également des moyens 45 de prétraitement des électrodes 4. Les moyens de prétraitement sont par exemple des moyens aptes à effectuer un nettoyage de la surface des électrodes 4 avant le dépôt des particules 21 et ainsi améliorer la force d'adhérence des couches catalytiques.

Les moyens 35 et des moyens 45 sont également avantageusement aptes à effectuer un post traitement des électrodes et des couches catalytiques.

Les moyens de post traitement sont par exemple des moyens aptes à effectuer un traitement thermique de la surface des électrodes 4 ou des couches catalytiques similaire à celui effectué par les moyens 40, pour un post traitement in situ.

Le post traitement peut également être effectué dans des moyens externes, autres que l'enceinte 31.

Ce traitement thermique peut s'effectuer sous gaz azoté et permet d'activer le catalyseur qui vient d'être déposé sur les électrodes.

On va maintenant décrire plusieurs exemples de familles de procédés de réalisation d'une couche catalytique selon l'invention.

Les exemples qui suivent ont été effectués sur un dispositif 30 utilisant une source d'ions du type canon à grille de type Kauffman. Les exemples numériques sont donc donnés à titre indicatif et non limitatif. D'autres sources d'ions, ne possédant par exemple pas de grille, peuvent évidemment être utilisées, ce qui modifie les valeurs de certains paramètres données dans la présente description.

Dans tous les exemples qui vont suivre, l'énergie du faisceau d'ions est comprise entre 50 et 1000 eV, et préférentiellement entre 300 et 600 eV.

Les densités de courant correspondantes sont comprises entre 0.1 et 10 mA/cm². Préférentiellement, elles sont comprises entre 0.1 et 0.3 mA/cm².

Avec de tels paramètres, la vitesse de dépôt des particules de catalyseur sur les électrodes est comprise entre 0.1 angströms/s et 10 angströms/s.

On comprend qu'un compromis doit être trouvé entre d'une part une énergie et une densité de faisceau d'ions relativement élevées, afin de permettre d'homogénéiser la couche catalytique ou de la perturber, et une énergie et une densité de faisceau pas trop fortes pour éviter d'enlever de l'électrode les particules juste après leur dépôt. Dans ce dernier cas, la vitesse d'érosion est plus importante que la vitesse de dépôt.

On utilise un faisceau d'ions comportant des ions de gaz rares, comme des ions Ar⁺, Kr⁺ ou Xe⁺ par exemple, ou des ions de gaz réactifs, comme par exemple des ions issus du dichlore Cl₂⁺, du difluor F₂⁺, du disoufre S₂⁺, diazote N₂⁺ ou de dioxygène O₂⁺.

On utilise un matériau catalyseur ayant une structure de type métal, cermet ou lanthanide.

La taille des particules de catalyseur dépend des applications recherchées. La taille des particules déposées est avantageusement comprise entre 1 et 20 nm, préférentiellement comprise entre 1 et 10 nm, par exemple de l'ordre de 7 nm, et très préférentiellement la taille des particules est comprise entre 1 et 4 nm.

Préférentiellement, la pression dans l'enceinte est maintenue inférieure à 10⁻³ bar. Préférentiellement encore, elle est comprise entre 10⁻⁴ et 5. 10⁻⁴ bar.

La température à l'intérieur de l'enceinte 31 peut être comprise entre la température ambiante et une température de l'ordre de 400°C selon les dépôts.

La vitesse de rotation des moyens 33 de support peut être comprise entre 1 et 40 tours par minute.

Avec les conditions expérimentales citées ci-dessus, on obtient typiquement des couches catalytiques d'épaisseur comprises entre 1 et 1000 angströms (entre 0.1 et 100 nm).

Bien entendu, on peut effectuer un dépôt alterné de couches catalytiques et d'un autre matériau, le matériau de l'électrode par exemple, de sorte à avoir une structure empilée et alternée.

On peut ainsi empiler des couches alternées dans la limite de la bonne tenue du dépôt, leur nombre dépendant de l'application.

### EXEMPLE 1 DE FAMILLES DE PROCEDES.

On va décrire ici un premier exemple de famille de procédés de réalisation de couche catalytique sur une électrode.

Cette première famille utilise les propriétés de catalyse des métaux.

Ainsi, les matériaux catalyseurs peuvent être du type platine, cobalt, manganèse, fer, nickel, cuivre, zinc, ruthénium, rhodium, palladium, argent, cadmium, rhénium, iridium, osmium ou or. Cette liste est non limitative.

Un dépôt a été réalisé avec une énergie de 600 eV et une densité de faisceau de 0,2 mA/cm². Le gaz utilisé pour le bombardement ionique est N₂.

Préférentiellement, on utilise des métaux de transition possédant des propriétés de catalyse intrinsèques. Ces métaux sont le nickel, le palladium ou le platine.

Préférentiellement, on utilise le platine dans une série d'exemples qui vont suivre.

On réalise alors un dépôt de platine, avec un bombardement ionique dont l'énergie est comprise entre 300 et 600 eV, et dont la densité est comprise entre 0.1 et 0.3 mA/cm². Le faisceau d'ions est constitué d'oxygène, ou d'un mélange argon/oxygène.

La taille des particules déposées est avantageusement comprise entre 5 et 20 nm, préférentiellement comprise entre 5 et 10 nm, et très préférentiellement la taille des particules est de l'ordre de 7 nm.

Pour certaines applications cependant, la taille des particules est très préférentiellement comprise entre 1 et 4 nm.

On obtient une couche catalytique d'épaisseur comprise entre 1 et 100 nm.

L'utilisation de gaz réactifs est possible. On peut par exemple utiliser le O₂⁺.

Un dépôt de platine a par exemple été réalisé avec une énergie de 600 eV et une densité de faisceau de 0,2 mA/cm². Le gaz utilisé pour le bombardement ionique est O₂ ou un mélange O₂/Ar dans les proportions 50/50.

Dans une autre série de manipulations, on utilise le cobalt ou un autre métal de type IV.

Le cobalt ne possède pas de propriétés catalytiques intrinsèques. Il doit donc préférentiellement être associé à un faisceau ionique de diazote N₂⁺ ou de dioxygène O₂⁺.

On réalise alors un dépôt de cobalt, avec un bombardement ionique dont l'énergie est comprise entre 300 et 600 eV, et dont la densité est comprise entre 0.1 et 0.3 mA/cm². Le faisceau d'ions est constitué d'oxygène, d'un mélange argon/oxygène ou d'azote
On obtient une couche catalytique d'épaisseur comprise entre 1 et 100 nm.

### EXEMPLE 2 DE FAMILLES DE PROCEDES.

On va décrire ici un deuxième exemple de famille de procédés de réalisation de couche catalytique sur une électrode.

Cette deuxième famille utilise les propriétés de catalyse des cermets comportant au moins un métal. On rappelle qu'un cermet est un matériau composite fritté constitué d'au moins une phase métallique et d'au moins une phase non métallique généralement de caractère céramique.

Préférentiellement le métal est un métal de transition.

Préférentiellement encore, le cermet est du type Ni-ZrO₂. Cette liste est non limitative.

Ce type de catalyseur est préférentiellement utilisé pour un dépôt sur une électrode anodique.

### EXEMPLE 3 DE FAMILLES DE PROCEDES.

On va décrire ici un troisième exemple de famille de procédés de réalisation de couche catalytique sur une électrode.

Cette troisième famille utilise les propriétés de catalyse des composés de lanthane, par exemple les oxydes et les fluorures de lanthane.

Préférentiellement, la structure du composé de lanthane est du type LaₓSr₁₋ₓMO_{3±δ} avec M=Mn, Al ou Fe. Cette liste est non limitative.

Préférentiellement encore, le M est du manganèse.

Ce type de catalyseur est préférentiellement utilisé pour un dépôt sur une électrode cathodique.

La technique précédemment décrite possède de nombreux avantages, notamment le contrôle de la taille des particules déposées et le contrôle de la structure de la couche catalytique, notamment son épaisseur - éventuellement multicouche - ainsi que sa force d'adhésion à l'électrode.

Elle permet également de déposer de faibles quantités de particules catalytiques. On peut ainsi ne déposer que 0.1 mg de catalyseur par cm² de surface géométrique, ce qui représente environ 10 fois moins que l'art antérieur.

Les couches catalytiques sont donc plus efficaces et moins onéreuses.

Les développements qui précèdent s'appliquent avantageusement aux électrodes en graphite ou sur un support poreux conducteur électrique. On peut par exemple utiliser des mousses métalliques. On peut préférentiellement utiliser un support par exemple sous forme de toile non tissée de carbone ou en tissu de carbone ou en papier de carbone ou en un quelconque support de matière carbonée.

On comprend ainsi que les électrodes peuvent être produites en continu sur des toiles qui sont ensuite enroulées sur elles même continûment grâce à des moyens 44 du dispositif 30 permettant de faire défiler l'électrode continûment dans l'enceinte. On a ainsi des gains de productivité. Bien entendu, la rotation des moyens support 33 n'est alors pas activée lors du défilement.

On peut ensuite appliquer ces électrodes sur des membranes solides sous forme de polymères ou des ensembles membrane électrolytique/électrodes des piles à combustibles. On presse alors par exemple à chaud la toile sur la membrane solide.

La membrane électrolytique est alors par exemple une membrane polymére de la marque Nafion ou du type polysulfone sulphonée. De façon générale, la membrane polymére comporte une substance conductrice ionique telles que des solutions d'ionomères de polymères perfluorosulfonates, comme une substance des marques Nafion 117, Flemion ou Aciplex. La membrane peut également comporter d'autres matériaux, comme par exemple des polymères sulfonés à base de siloxanes, des polysulfones ou des polyéthercétones ou des polyétheréthercétones ou des polyoxydes de phénylène ou des polybenzoxazoles.

On peut également appliquer, selon une variante, des procédés de réalisation de couches catalytiques similaires directement sur des membranes solides ou poreuses. On peut alors appliquer avantageusement les particules catalyseurs - le platine par exemple - directement sur la membrane avant d'appliquer une couche de graphite ou de carbone par pulvérisation.

Bien entendu, la technique précédemment décrite s'applique à tous les types d'électrodes à gaz ou à liquides. On peut ainsi citer à titre d'exemples non limitatifs, le cas de toutes les électrodes des piles du type métal/air, les électrodes des piles alcalines et les électrodes des piles à acide phosphorique. On peut également citer le cas des électrodes des piles à membranes échangeuses de protons (Proton Exchange Membrane Fuel Cell). Elle peut plus généralement s'appliquer à tous les types de catalyse de production chimique ou notamment à des capteurs physiques utilisant des procédés catalytiques.

## Revendications

1. Procédé de dépôt sous vide d'une couche catalytique sur une électrode (4) à catalyse hétérogène dans une enceinte (31), **caractérisé en ce qu'**on assiste le dépôt sous vide du catalyseur par un bombardement ionique de l'électrode lors du dépôt du catalyseur.

2. Procédé selon la revendication 1, **caractérisé en ce que**, pour obtenir une couche catalytique donnée, on contrôle l'énergie cinétique et la densité du faisceau (37) d'ions en fonction du type d'ions bombardés.

3. Procédé selon la revendication 2, **caractérisé en ce que** l'énergie du faisceau (37) d'ions est comprise entre 50 et 1000 eV, la densité du faisceau étant comprise entre 0.1 et 10 mA/cm².

4. Procédé selon l'une des revendications 1 à 3, **caractérisé en ce qu'**on utilise un faisceau (37) d'ions comportant des ions de gaz rares ou des ions de gaz réactifs.

5. Procédé selon l'une des revendications 1 à 4, **caractérisé en ce qu'**on utilise un catalyseur (50) de type métal, cermet ou lanthanide.

6. Procédé selon la revendication 5, **caractérisé en ce que** le métal est du type platine, cobalt, manganèse, fer, nickel, cuivre, zinc, ruthénium, rhodium, palladium, argent, cadmium, rhénium, iridium, osmium ou or.

7. Procédé selon la revendication 5, **caractérisé en ce que** le cermet comportant au moins un métal de transition est du type Ni-ZrO₂.

8. Procédé selon la revendication 5, **caractérisé en ce que** le lanthanide est du type LaₓSr₁₋ₓMO_{3±δ} avec M=Mn, Al ou Fe.

9. Procédé selon l'une des revendications 1 à 8, **caractérisé en ce que** la taille des particules de catalyseur est inférieure à 10 nm.

10. Procédé selon la revendication 9, **caractérisé en ce que** la taille des particules est comprise entre 1 et 4 nm.

11. Procédé selon l'une des revendications 1 à 10, **caractérisé en ce qu'**on contrôle la température et la pression à l'intérieur de l'enceinte (31 ).

12. Procédé selon la revendication 11, **caractérisé en ce que** la pression dans l'enceinte (31) est maintenue inférieure à 10⁻³ bar.

13. Procédé selon l'une des revendications 1 à 12, **caractérisé en ce qu'**on effectue un pré ou un post traitement sur l'électrode ou la couche catalytique.

14. Procédé selon l'une des revendications 1 à 13, **caractérisé en ce qu'**on effectue un dépôt alterné de couches catalytiques et d'un matériau support de sorte à avoir une structure empilée.

15. Procédé selon l'une des revendications 1 à 14, **caractérisé en ce qu'**on utilise une électrode (4) en graphite ou un support poreux conducteur électrique, comme une toile non tissée de carbone ou en tissu de carbone ou en papier de carbone.

16. Procédé selon l'une des revendications 1 à 15, **caractérisé en ce qu'**on fait défiler continûment l'électrode (4) dans l'enceinte (31).

17. Procédé selon l'une des revendications 1 à 16, **caractérisé en ce que** l'électrode est une électrode à gaz.

18. Dispositif (30) de dépôt d'une couche catalytique sur une électrode (4) à catalyse hétérogène, comportant une enceinte (31), des moyens (32) de contrôle de la pression dans l'enceinte, des moyens (42) permettant de faire le vide, des moyens (33) de support de l'électrode dans l'enceinte, des moyens (34) d'évaporation d'un catalyseur (50) et en outre des moyens (35) aptes effectuer un bombardement (37) ionique de l'électrode lors du dépôt du catalyseur pour assister le dépôt sous vide du catalyseur, **caractérisé en ce qu'**il comporte des moyens (44) aptes à faire défiler l'électrode continûment dans l'enceinte (31 ).

19. Dispositif selon la revendication 18, **caractérisé en ce que** les moyens de bombardement comportent des moyens (38) aptes à contrôler l'énergie cinétique et la densité du faisceau d'ions en fonction du type d'ions bombardés.

20. Dispositif selon l'une des revendications 18 ou 19, **caractérisé en ce qu'**il comporte des moyens (40) aptes à contrôler la température à l'intérieur de l'enceinte.

21. Dispositif selon l'une des revendications 18 à 20, **caractérisé en ce qu'**il comporte des moyens (45, 35) aptes à effectuer un pré ou un post traitement sur l'électrode ou la couche catalytique.

22. Dispositif selon l'une des revendications 18 à 21, **caractérisé en ce qu'**il comporte des moyens (43) aptes à mettre en rotation les moyens (33) de support de l'électrode.
